# EUROPÄISCHE PATENTSCHRIFT

(11) **EP 0 340 479 B1**
(45) Veröffentlichungstag und Bekanntmachung des Hinweises auf die Patenterteilung: **07.07.1993**
(21) Anmeldenummer: 89106289.5
(22) Anmeldetag: 10.04.1989
(51) Int. Cl.: H03K 5/19, G01R 23/15

(54) **Anordnung zur Uberwachung eines Taktsignals**
Arrangement for monitoring a time base signal
Dispositif de contrôle d'un signal de base temps

(30) Priorität: 06.05.1988 DE 3815531
(43) Veröffentlichungstag der Anmeldung: 08.11.1989
(73) Patentinhaber: Heidelberger Druckmaschinen Aktiengesellschaft, D-69019 Heidelberg (DE)
(72) Erfinder: Hauck, Dieter, D-6930 Eberbach (DE); May, Karl-Heinz, D-6806 Viernheim (DE); Müller, Hans, D-6902 Sandhausen (DE); Rehberger, Jürgen, D-6915 Dossenheim (DE)
(74) Vertreter: Stoltenberg, Heinz-Herbert Baldo

(56) Entgegenhaltungen:
- DE-A- 2 848 641
- US-A- 4 467 285
- US-A- 4 583 013
- US-A- 4 737 723
- ELECTRONIC DESIGN, Band 29, Nr. 17, August 1981, Seiten 158-160, Waseca, MN, US; M. FRAPPIER: "Single NAND-gate quad detects loss of pulse stream"

## Beschreibung

Die Erfindung betrifft eine Anordnung zur Überwachung eines Taktsignals.

Die Funktion von elektronischen Steuer- und Regeleinrichtungen hängt häufig vom Vorhandensein eines Taktsignals ab. Bleibt ein Taktsignal wegen eines Fehlers des Taktsignalgenerators aus, so können Fehlfunktionen auftreten, die im Einzelfall ernsthafte Schäden nach sich ziehen können.

In der Patentschrift US 44 67 285 ist eine Taktsignalerkennungsschaltung beschrieben, die eine Überwachungsschaltung und eine Speicherschaltung enthält. Die Überwachungsschaltung erkennt den Ausfall des Taktsignals und wird periodisch von einem externen Impulszug zurückgesetzt. Die Speicherschaltung wird durch den externen Impulszug getaktet und speichert das Ausgangssignal der Überwachungsschaltung. Die Speicherschaltung kann von einem externen Signal oder von einer Flanke des zu überwachenden Taktsignals zurückgesetzt werden. Die Frequenz des externen Impulszuges, welcher die Speicherschaltung taktet, soll weniger als die Hälfte der Frequenz des zu überwachenden Taktsignals betragen. Als Überwachungs- und Speicherschaltung werden JK-Flip-Flops verwendet, wobei das zu überwachende Taktsignal über ein Gatter dem Takteingang des Überwachungs-Flip-Flops zugeführt wird und zwischen dem Ausgang dieses Flip-Flops und dem I-Eingang des Speicher-Flip-Flops ein Schalter vorgesehen ist.

Nachteilig bei dieser Lösung ist, daß der externe Impulszug zum periodischen Zurücksetzen des Überwachungs-Flip-Flops von einer externen Impulsquelle erzeugt werden muß, deren Frequenz o.g. Bedingung erfüllen muß. Bei niedrigen Frequenzen wird die Abfrage auf das Vorhandensein des zu überwachenden Taktsignals in relativ großen Zeitabständen vorgenommen, daß heißt, daß die Überwachungsschaltung zwischen zwei Flanken des Impulszuges inaktiv ist, so daß die Schaltung nicht zu jedem Zeitpunkt zuverlässig arbeitet.

Aufgabe der vorliegenden Erfindung ist es, eine Anordnung zur Überwachung eines Taktsignals zu entwickeln, welche einen geringen Schaltungsaufwand hat und welche die Zuverlässigkeit bei der Überwachung verbessert.

Die Aufgabe wird erfindungsgemäß mit dem Merkmalen des Anspruchs 1 gelöst.

Bei einer Weiterbildung der erfindungsgemäßen Anordnung ist vorgesehen, daß ein Einschalt-Rücksetzsignal den Setzeingängen der D-Flip-Flops und dem Rücksetzeingang des monostabilen Multivibrators zuführbar ist. Bei Steuer- bzw. Regeleinrichtungen, welche nach dem Einschalten ohnehin durch ein Einschalt-Rücksetzsignal in einen Anfangszustand gebracht werden, wird durch diese Weiterbildung ohne zusätzlichen Aufwand ermöglicht, daß die erfindungsgemäße Anordnung unmittelbar nach dem Einschalten die Überwachung des Taktsignals aufnimmt.

Bei einer anderen Weiterbildung der erfindungsgemäßen Anordnung ist eine einfache Erzeugung des Vergleichssignals dadurch vorgesehen, daß zur Ableitung des Vergleichssignals aus der Netzspannung eine Schwellwertschaltung vorgesehen ist.

Ein Ausführungsbeispiel der Erfindung ist in der Zeichnung anhand mehrerer Figuren dargestellt und in der nachfolgenden Beschreibung näher erläutert. Es zeigt:
- Fig. 1: ein Blockschaltbild des Ausführungsbeispiels und
- Fig. 2: Zeitdiagramme der bei der Anordnung nach Fig. 1 auftretenden Signale.

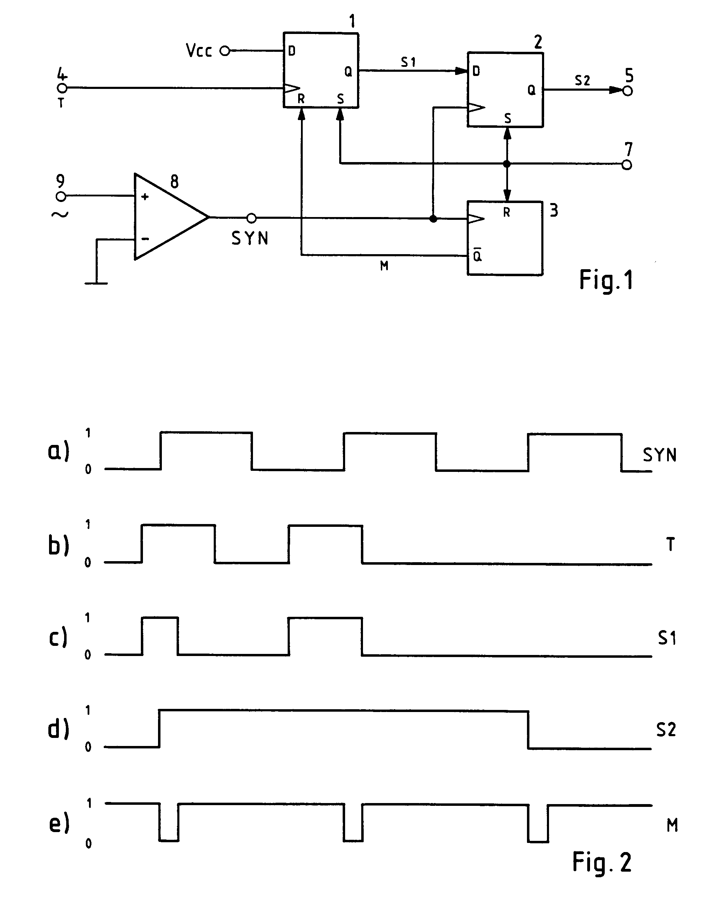

Die in Fig. 1 dargestellte Anordnung besteht aus zwei D-Flip-Flops 1, 2 und einem monostabilen Multivibrator 3. Über einen Eingang 4 wird dem Takteingang des D-Flip-Flops 1 das zu überwachende Taktsignal T zugeführt. Der D-Eingang des D-Flip-Flops 1 liegt an der Betriebsspannung Vcc. Der Ausgang Q des D-Flip-Flops 1 ist mit dem D-Eingang des D-Flip-Flops 2 verbunden, während der Ausgang Q des D-Flip-Flops 2 den Ausgang 5 der Anordnung bildet. Ein Vergleichssignal SYN wird den Takteingängen des D-Flip-Flops 2 und des monostabilen Multivibrators 3 zugeführt. Das Signal am Ausgang Q̅ des monostabilen Multivibrators 3 dient zum Rücksetzen des D-Flip-Flops 1 und wird dazu an einen dynamisch wirkenden Reset-Eingang des D-Flip-Flops 1 geführt. Ein bei 7 zugeführtes Einschalt-Rücksetzsignal setzt die beiden D-Flip-Flops 1, 2 und wird außerdem einem Rücksetz-Eingang des monostabilen Multivibrators 3 zugeleitet.

Das Vergleichssignal SYN wird durch eine Schwellwertschaltung 8 aus der Netzspannung abgeleitet, wozu einem Eingang 9 eine Wechselspannung zugeführt ist, welche der nicht dargestellten Sekundärwicklung eines Netztransformators entnommen wird.

Die Funktion der Anordnung nach Fig. 1 und das erfindungsgemäße Verfahren werden im folgenden anhand von Fig. 2 erläutert. Das in Zeile a) der Fig. 2 dargestellte Signal ist ein aus der Netzspannung gewonnenes mäanderförmiges Signal. Bei dem in Zeile b) dargestellten Taktsignal T wird angenommen, daß zwei Impulse vorhanden sind und daß danach das Taktsignal ausfällt.

Zeile c) stellt das Ausgangssignal des D-Flip-Flops 1 dar. Es wird mit der Vorderflanke des Taktsignals T auf den Wert 1 gebracht. Bei Eintreffen der Vorderflanke des Vergleichssignals SYN wird der Wert des Ausgangssignals S1 des D-Flip-Flops 1 in das D-Flip-Flop 2 übernommen, worauf das Ausgangssignal S2 (Zeile d)) des D-Flip-Flops 2 ebenfalls den Wert 1 annimmt. Gleichzeitig wird der monostabile Multivibrator 3 (Fig. 1) getaktet, dessen Ausgangssignal in Zeile e) dargestellt ist. Mit der Vorderflanke des Ausgangssignals M wird das D-Flip-Flop 1 rückgesetzt.

Dieses wiederholt sich solange, wie das Taktsignal T vorhanden ist. Bleibt es jedoch aus, so wird das Ausgangssignal S1 des D-Flip-Flops 1 nicht auf den Wert 1 gesetzt, so daß durch das D-Flip-Flop 2 keine 1 übernommen werden kann. Der Ausgang 5 geht somit auf 0, was durch eine geeignete Anzeigervorrichtung angezeigt werden kann. Je nach Anforderungen im Einzelfall können auch andere Maßnahmen ergriffen werden, wie beispielsweise das automatische Anhalten einer Maschine.

## Patentansprüche

1. Anordnung zur Überwachung eines Taktsignals,
bestehend aus zwei Flip-Flop-Schaltungen (1, 2), wobei der Takteingang der ersten Flip-Flop-Schaltung (1) mit einer Taktsignalquelle verbunden ist,
wobei weiterhin der Takteingang der zweiten Flip-Flop-Schaltung (2) mit einer Vergleichssignalquelle verbunden ist,
und wobei bei Ausfall des Taktsignals am Ausgang der zweiten Flip-Flop-Schaltung (2) ein Überwachungssignal entnehmbar ist,
**dadurch gekennzeichnet,**
daß als Flip-Flop-Schaltungen D-Flip-Flops (1, 2) vorgesehen sind,
wobei der D-Eingang des ersten Flip-Flops (1) mit einem festen logischen Pegel (Vcc) und der Ausgang des ersten D-Flip-Flops (1) mit dem D-Eingang des zweiten D-Flip-Flops (2) verbunden ist,
daß die Vergleichssignalquelle mit den Takteingängen des zweiten D-Flip-Flops (2) und eines monostabilen Multivibrators (3) verbunden ist,
und daß ein Ausgang des monostabilen Multivibrators (3) an dem Rücksetzeingang des ersten D-Flip-Flops (1) angeschlossen ist.

2. Anordnung nach Anspruch 1,
**dadurch gekennzeichnet,**
daß ein Einschalt-Rücksetzsignal den Setzeingängen der D-Flip-Flops (1, 2) und dem Rücksetzeingang des monostabilen Multivibrators (3) zuführbar ist.

3. Anordnung nach Anspruch 1,
**dadurch gekennzeichnet,**
daß zur Ableitung des Vergleichssignals aus der Netzspannung eine Schwellwertschaltung (8) vorgesehen ist.

## Claims

1. Arrangement for monitoring a clock signal, consisting of two flipflop circuits (1, 2), the clock input of the first flipflop circuit (1) being connected to a clock signal source, the clock input of the second flipflop circuit (2) furthermore being connected to a reference signal source, and a monitoring signal being extractable at the output of the second flipflop circuit (2) if the clock signal fails, characterised in that D-type flipflops (1,2) are provided as flipflop circuits, the D input of the first flipflop (1) being connected to a fixed logic level (Vcc) and the output of the first D-type flipflop (1) being connected to the D input of the second D-type flipflop (2), in that the reference signal source is connected to the clock inputs of the second D-type flipflop (2) and of a monostable multivibrator (3), and in that an output of the monostable multivibrator (3) is connected to the reset input of the first D-type flipflop (1).

2. Arrangement according to Claim 1, characterised in that a switching-on/reset signal can be supplied to the set inputs of the D-type flipflops (1, 2) and to the reset input of the monostable multivibrator (3).

3. Arrangement according to Claim 1, characterised in that a threshold circuit (8) is provided for deriving the reference signal from the mains voltage.

## Revendications

1. Dispositif de contrôle d'un signal d'horloge, se composant de deux circuits formant bascules (1, 2), l'entrée d'horloge de la première bascule (1) étant reliée à une source de signaux d'horloge, et en outre l'entrée d'horloge de la seconde bascule (2) étant reliée à une source de signaux de comparaison, et en outre, lors d'une suppression du signal d'horloge, un signal de contrôle peut être obtenu à la sortie de la seconde bascule (2), caractérisé en ce qu'il est prévu comme circuits formant bascules des bascules-D (1, 2), l'entrée-D de la première bascule (1) est reliée à un niveau logique fixe (Vcc) et la sortie de la première bascule-D (1) est reliée à l'entrée-D de la seconde bascule (2), en ce que la source de signaux de comparaison est reliée aux entrées d'horloge de la seconde bascule-D (2) et à un multivibrateur monostable (3) et en ce qu'une sortie du multivibrateur monostable (3) est reliée à l'entrée de retour à l'état initial de la première bascule-D (1).

2. Dispositif selon la revendication 1, caractérisé en ce qu'un signal d'enclenchement- retour à l'état initial peut être appliqué aux entrées d'activation des bascules-D (1, 2) et à l'entrée de retour à l'état initial du multivibrateur monostable (3).

3. Dispositif selon la revendication 1, caractérisé en ce qu'il est prévu un circuit à valeur de seuil (8) pour dériver le signal de comparaison de la tension du secteur.
